# EUROPEAN PATENT APPLICATION

(11) **EP 1 647 992 A1**
(43) Date of publication of application: **19.04.2006**
(21) Application number: 04024528.4
(22) Date of filing: 14.10.2004
(51) Int. Cl.: G11C 29/00

(54) **Memory circuit with a substitution memory for faulty memory cells**

(71) Applicant: Infineon Technologies AG, 81669 München (DE)
(72) Inventor: Jallamion-Grive, Yannis, 06250 Mougins (FR); Collura, Michel, 83300 Draguignan (FR)
(74) Representative: Graf Lambsdorff, Matthias

(57) **Abstract**

A memory circuit (MEM_CIRC_2) comprises a main memory block (MEM), a substitution memory block (RED_REG) for substitution of faulty memory cells in the main memory block (MEM) and a control mean (CONTR_LOG) that activates the substitution memory block (RED_REG) and leaves the main memory block (MEM) inactivated in case of an access to a faulty memory cell and that redirects this access to the substitution memory block (RED_REG).

## Description

The invention relates to memory circuits that comprise a main memory block as well as a substitution memory block. In the substitution memory block the memory contents of faulty memory cells of the main memory block is stored.

RAM (random access memory) circuits may contain one or more randomly distributed defective memory cells after fabrication. Without appropriate countermeasures such RAM circuits with faulty memory cells would be unusable for most applications even if only a small number of memory cells compared to the total number is affected.

A general concept to prevent most RAM memories from being discarded because of defective memory cells is to provide redundant registers. For that, the faulty memory cells are located during a memory test and substitution memory cells are provided which allow to substitute the faulty memory cells within the main memory. The address codes of the substituted memory cells are normally stored in non-volatile memory cells, which are generally implemented by fuses. If a memory cell is accessed, the stored address information is compared with the actual address information of the address signal. In case of a positive comparison result the access is redirected to the substitution memory.

A drawback of the concept described above is that in case of a read or write access to faulty memory cells not only the redundant registers located in the substitution memory are activated but also the faulty memory cells. Thus, each time the user reads or writes to a faulty address, the cells causing the faulty address are also activated even though this memory address is replaced by registers located in the substitution memory.

After several accesses to a faulty memory cell this procedure may damage the cells situated in proximity to the faulty cell and also the corresponding bitline or wordlines. The reason for this is that a faulty address contains a memory cell with a shortcut. Every time this memory cell is activated, a current peak occurs on the power line. After several accesses to this faulty memory cell the power line is likely to blow and all memory cells connected to this power line will be damaged. At the end the entire memory block may be corrupted by this.

It is therefore an object of the invention to provide a memory circuit comprising a main memory block and a substitution memory block, which prohibits the access to faulty memory addresses. A method for the same purpose shall also be provided.

The above formulated object on which the invention is based is achieved by a memory circuit according to claim 1 and a method according to claim 9.

Preferred and advantageous embodiments of the memory circuit according to claim 1 are subject matter of claims 2 to 8. Preferred and advantageous embodiments of the method according to claim 9 are subject matter of claims 10 to 13.

The memory circuit according to the invention comprises a main memory block, a substitution memory block and a control mean.

The memory contents of faulty memory cells situated in the main memory block is stored in the substitution memory block. Thus, the registers in the substitution memory block are able to substitute faulty memory cells of the main memory block.

As long as no access to the memory circuit occurs, both the main memory block and the substitution memory block are inactivated. In case of an access to the main memory block involving one or more defective memory cells, the control mean activates the substitution memory block. Contrary to the substitution memory block the main memory block is left inactivated by the control mean if an address containing a faulty memory is accessed. Furthermore the control mean redirects this access to the substitution memory block.

Activating the substitution memory block does not necessarily mean that the substitution memory block is activated entirely. It is also possible to activate only those registers of the substitution memory block that are needed for the access.

Compared to conventional memory circuits comprising a main memory block and a substitution memory block, the memory circuit according to the invention avoids to activate an address of the main memory block that is found to contain a defective memory cell. Since this inhibits the propagation of defects to other memory cells in the proximity to faulty memory cells, the solution according to the invention results in a longer lifetime of the main memory block. The invention also offers a reduced power consumption of the memory circuit because the number of memory cells that are activated is reduced.

It can advantageously be provided that the control mean comprises a comparator that compares the addresses involved in an access to the main memory block with the addresses of the faulty memory cells.

In order to be able to handle accesses to faultless memory cells, the control mean advantageously activates the main memory block in such a case and leaves the substitution memory block inactivated. Moreover such an access is directed to the main memory block by the control mean. Instead of activating the entire main memory block it is sufficient to activate only those memory cells that are needed for the access.

In accordance with one advantageous configuration of the invention, the addresses of faulty memory cells are stored in a non-volatile address memory. Thus, even after a power-down these addresses remain saved in the non-volatile address memory. The faulty memory cells and their addresses can for example be detected by running a BIST (built-in self test).

In case of an access to the main memory block the comparator compares the addresses involved in this access to the addresses stored in the non-volatile address memory.

According to the invention an access to the main memory block can be both, a read and a write access.

The memory circuit according to the invention can advantageously exhibit the following features: A CSB (chip select bit) input terminal is provided. On the CSB input terminal a signal can be received indicating an access to the main memory block. The comparator advantageously has an output terminal, on which a signal indicating an access to a faulty memory cell is generated. Moreover the control mean comprises a first OR gate, a second OR gate and a first inverter.

The first OR gate has a first input terminal fed by the output terminal of the comparator and a second input terminal connected to the CSB input terminal. Furthermore the first OR gate has an output terminal generating a signal for activating the substitution memory block in case of an access to a faulty memory cell.

The second OR gate has a first input terminal fed by the output terminal of the comparator and a second input terminal connected to the CSB input terminal. The second OR gate also has an output terminal generating a signal for activating the main memory block in case of an access only to faultless memory cells.

The first inverter is arranged between the output terminal of the comparator and the first input terminal of the first OR gate or the first input terminal of the second OR gate. This means that the input terminal of the first inverter is connected to the output terminal of the comparator and that the first input terminal of either the first OR gate or the second OR gate is connected to the output terminal of the first inverter instead of being connected to the output terminal of the comparator.

Furthermore, it can advantageously be provided that the memory circuit according to the invention contains a multiplexer. The multiplexer has a first input terminal connected to a data output terminal of the main memory block and a second input terminal connected to a data output terminal of the substitution memory block.

Advantageously, the memory circuit has an RWB input terminal for receiving a signal indicating a read access or a write access to the main memory block. Furthermore, the control mean comprises an AND gate. The function of the AND gate is to control the multiplexer. For that, the AND gate has a first input terminal connected to the output terminal of the comparator, a second input terminal connected to the CSB input terminal via a second inverter, a third input terminal connected to the RWB input terminal and an output terminal connected to a control terminal of the multiplexer.

In accordance with the present invention, a method of controlling an access to a memory circuit, which contains a main memory block and a substitution memory block for substitution of faulty memory cells in the main memory block, is comprised of the following steps:
(a) Activating the substitution memory block and leaving the main memory block inactivated in case of an access to a faulty memory cell; and
(b) Redirecting this access to the substitution memory block.

The method according to the invention offers the same advantages over conventional methods as the memory circuit according to claim 1.

The invention is explained below in an exemplary manner with reference to the drawings, in which
- Fig. 1: shows a memory circuit according to prior art;
- Fig. 2: shows an exemplary embodiment of the memory circuit according to the invention; and
- Fig. 3: shows an exemplary embodiment of the control logic of the memory circuit shown in Fig. 2.

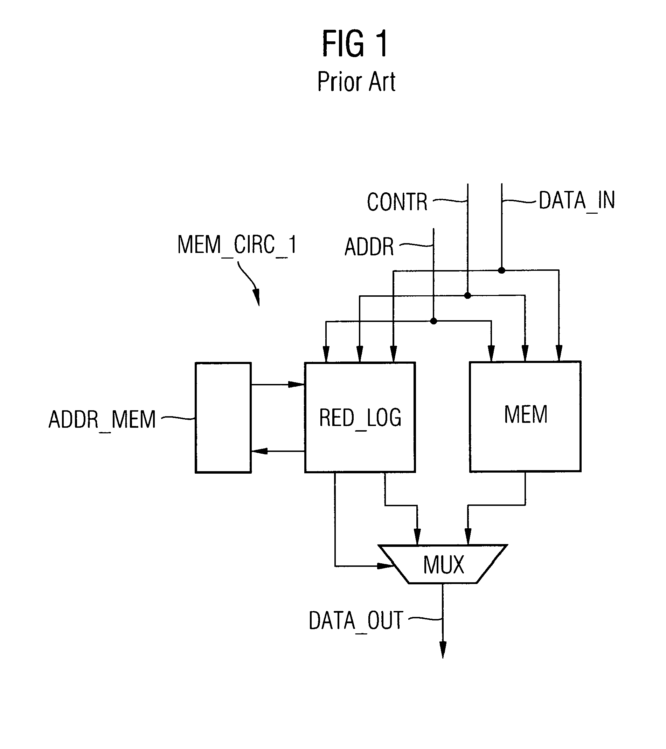

Fig. 1 shows a conventional memory circuit MEM_CIRC_1 according to prior art. The architecture depicted in Fig. 1 comprises a main memory MEM, a redundancy logic RED_LOG, a non-volatile address memory ADDR_MEM and a multiplexer MUX. The main memory MEM is typically a RAM.

The redundancy logic RED_LOG and the main memory MEM can be fed with an address signal ADDR, a control signal CONTR and input data DATA_IN. The data output terminals of the main memory MEM and the redundancy logic RED_LOG are connected to the input terminals of the multiplexer MUX. On the output terminal of the multiplexer MUX output data DATA_OUT can be outputted. The control terminal of the multiplexer MUX is fed by the redundancy logic RED_LOG. Between the non-volatile address memory ADDR_MEM and the redundancy logic RED_LOG addresses and control signals can be exchanged.

Prior to use of the main memory MEM, tests are performed in order to detect faulty memory cells in the main memory MEM. Once a faulty memory cell is found, the address of this memory cell will be stored in the non-volatile address memory ADDR_MEM. The non-volatile address memory ADDR_MEM is a so-called fuse box. The memory contents that are intended to be stored in the faulty memory cells of the main memory MEM are instead stored in redundant registers located in the redundancy logic RED_LOG.

The memory circuit MEM_CIRC_1 functions as follows. When a read or a write access to the main memory MEM occurs, the address information of this access, which is given by the address signal ADDR, is compared by the redundancy logic RED_LOG to the addresses stored in the non-volatile address memory ADDR_MEM. In case the access contains an address of a faulty memory cell, the access is redirected to the redundancy logic RED_LOG. This means that in case of a read access output data DATA_OUT are outputted from the redundancy logic RED_LOG and in case of a write access input data DATA_IN are stored in the redundant registers of the redundancy logic RED_LOG.

A disadvantage of the conventional memory circuit MEM_CIRC_1 is that faulty addresses in the main memory MEM can be still activated, although the main memory MEM is not involved in a data transfer in such a case. In the long run this behaviour may lead to a breakdown of the entire main memory MEM as explained above.

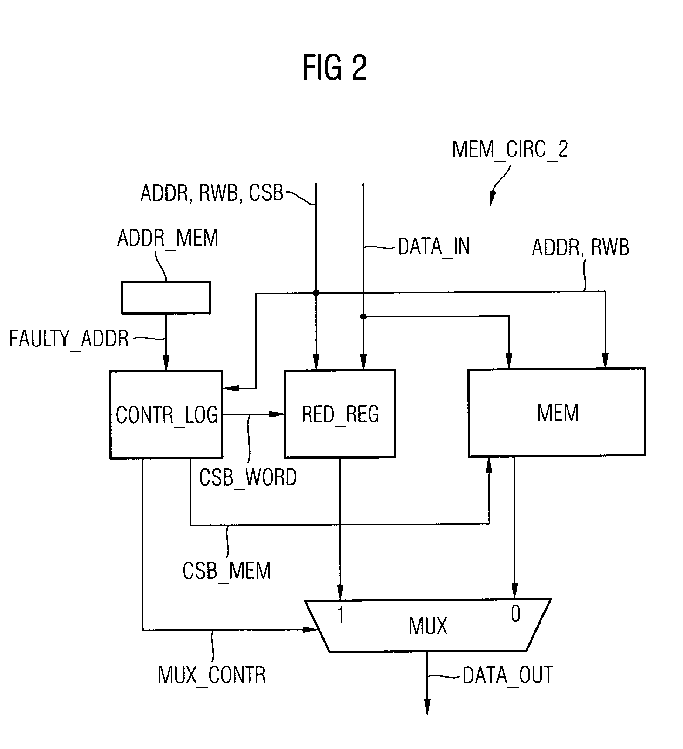

The disadvantage of the conventional memory circuit MEM_CIRC_1 is overcome by the memory circuit MEM_CIRC_2 depicted in Fig. 2. The memory circuit MEM_CIRC_2 is an exemplary embodiment of the memory circuit according to the invention.

Equally to the conventional memory circuit MEM_CIRC_1 the memory circuit MEM_CIRC_2 according to the invention comprises a main memory MEM, a non-volatile address memory ADDR MEM and a multiplexer MUX. However, instead of the redundancy logic RED_LOG the memory circuit MEM_CIRC_2 contains a control logic CONTR_LOG and redundant registers RED_REG.

The control logic CONTR_LOG can be fed with address signals ADDR and FAULTY_ADDR as well as with control signals CSB (chip select bit) and RWB (read/write bit). The control logic CONTR_LOG generates control signals CSB_WORD, CSB_MEM and MUX_CONTR controlling the redundant registers RED_REG, the main memory MEM and the multiplexer MUX, respectively.

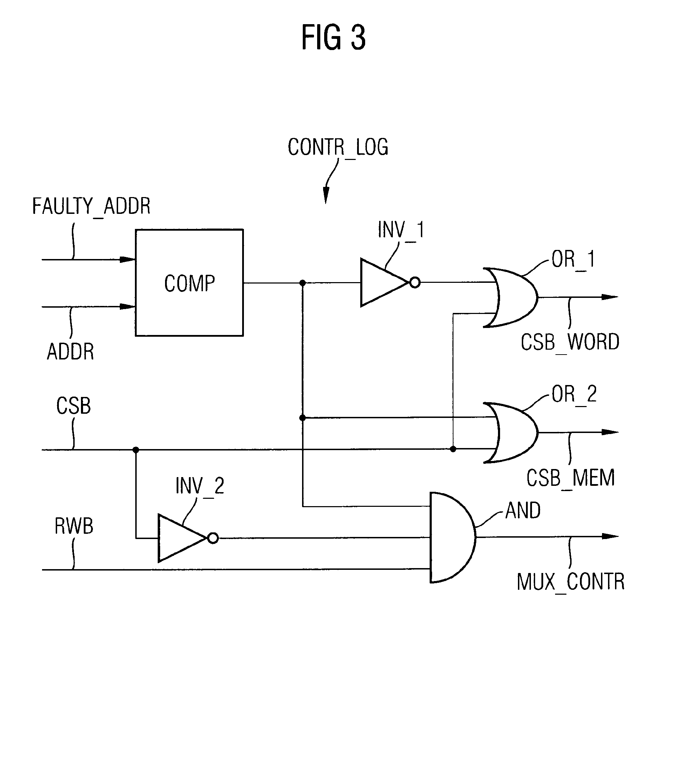

Details of the control logic CONTR_LOG are shown in Fig. 3. The control logic CONTR_LOG comprises a comparator COMP, whose input terminals are fed with the address signals FAULTY_ADDR and ADDR. The output terminal of the comparator COMP feeds the first input terminal of an OR gate OR 1 via an inverter INV_1. Furthermore, the output terminal of the comparator COMP is connected to the first input terminals of an OR gate OR_2 and an AND gate AND, respectively. The second input terminals of the OR gates OR_1 and OR_2 are fed with the control signal CSB, respectively. The control signal CSB is also conveyed to the second input of the AND gate AND via an inverter INV_2. The third input of the AND gate AND is fed with the control signal RWB.

The OR gates OR_1 and OR_2 and the AND gate AND output the control signals CSB_WORD, CSB_MEM and MUX_CONTR on their output terminals, respectively.

By convention the control signal CSB is 0 in case of an access and 1 otherwise. It is also a convention that the control signal RWB is 0 in case of a write access and 1 in case of a read access.

If the circuit memory CIRC_MEM_2 is accessed, the address delivered by the address signal ADDR is compared to the addresses of the faulty memory cells stored in the non-volatile address memory ADDR_MEM. If the address of the access is found to be an address containing a faulty memory cell, the comparator COMP produces a 1 on its output terminal. Because of the arrangement of the control logic CONTR_LOG the control signal CSB_WORD then becomes 0 and the control signal CSB_MEM becomes 1. This results in activating the redundant registers RED_REG and leaving the main memory MEM inactivated.

If the access to the memory circuit MEM_CIRC_2 does not involve a faulty address, the comparator COMP produces a 0 at its output terminal and consequently the control signal CSB_WORD becomes 1 and the control signal CSB_MEM becomes 0. Then the corresponding memory cells in the main memory MEM are activated and the redundant registers RED_REG remain inactivated.

If the access to the memory circuit MEM_CIRC_2 is a write access, the input data DATA_IN are stored in either the redundant registers RED_REG or the main memory MEM depending on which of these memories is activated.

If the access to the memory circuit MEM_CIRC_2 is a read access to faulty addresses, the control signal MUX_CONTR is 1 causing the multiplexer MUX to output data from the activated redundant registers RED_REG as output data DATA_OUT.

If the access to the memory circuit MEM_CIRC_2 is a read access to faultless addresses, the control signal MUX_CONTR is 0 causing the multiplexer MUX to output data from the activated main memory MEM as output data DATA_OUT.

Recapitulating it can be concluded that the memory circuit MEM_CIRC_2 according to the invention is advantageous compared to the conventional memory circuit MEM_CIRC_1 because the control logic CONTR_LOG avoids to activate faulty memory cells of the main memory MEM. This difference between the memory circuits MEM_CIRC_1 and MEM_CIRC_2 results in a longer lifetime and a lower power consumption of the memory circuit MERM_CIRC_2.

## Claims

1. A memory circuit (MEM_CIRC_2) comprising:
- a main memory block (MEM),
- a substitution memory block (RED_REG) for substitution of faulty memory cells in the main memory block (MEM),
- a control mean (CONTR_LOG) that is designed to activate the substitution memory block (RED_REG) and to leave the main memory block (MEM) inactivated in case of an access to a faulty memory cell and to redirect this access to the substitution memory block (RED_REG).

2. The memory circuit (MEM_CIRC_2) according to claim 1,
**characterized in that**
- the control mean (CONTR_LOG) comprises a comparator (COMP) comparing the addresses involved in an access to the memory circuit (MEM_CIRC_2) with the addresses of the faulty memory cells.

3. The memory circuit (MEM_CIRC_2) according to claim 1 or according to claim 2,
**characterized in that**
- the control mean (CONTR_LOG) is further designed to activate the main memory block (MEM) and to leave the substitution memory block (RED_REG) inactivated in case of an access to a faultless memory cell and to direct this access to the main memory block (MEM).

4. The memory circuit (MEM_CIRC_2) according to one or more of the preceding claims,
**characterized in that**
- the memory circuit (MEM_CIRC_2) comprises a non-volatile address memory (ADDR_MEM), in which the addresses of faulty memory cells of the main memory block (MEM) are stored.

5. The memory circuit (MEM_CIRC_2) according to one or more of the preceding claims,
**characterized in that**
- an access to the memory circuit (MEM_CIRC_2) is a read or a write access.

6. The memory circuit (MEM_CIRC_2) according to one or more of the preceding claims,
**characterized in that**
- the memory circuit (MEM_CIRC_2) has a CSB input terminal for receiving a signal (CSB) indicating an access to the main memory block (MEM),
- the comparator (COMP) has an output terminal for generating a signal indicating an access to a faulty memory cell, and
- the control mean (CONTR_LOG) comprises
- a first OR gate (OR_1) having a first input terminal connected to the output terminal of the comparator (COMP), a second input terminal connected to the CSB input terminal (CSB) and an output terminal for generating a signal (CSB_WORD) for activating the substitution memory block (RED_REG) in case of an access to a faulty memory cell,
- a second OR gate (OR_2) having a first input terminal connected to the output terminal of the comparator (COMP), a second input terminal connected to the CSB input terminal (CSB) and an output terminal for generating a signal (CSB_MEM) for activating the main memory block (MEM) in case of an access only to faultless memory cells, and
- a first inverter (INV 1) being arranged between the output terminal of the comparator (COMP) and the first input terminal of the first OR gate (OR_1) or of the second OR gate (OR_2).

7. The memory circuit (MEM_CIRC_2) according to one or more of the preceding claims,
**characterized in that**
- the memory circuit (MEM_CIRC_2) comprises a multiplexer (MUX) having a first input terminal connected to a data output terminal of the main memory block (MEM) and a second input terminal connected to a data output terminal of the substitution memory block (RED_REG).

8. The memory circuit (MEM_CIRC_2) according to claim 7,
**characterized in that**
- the memory circuit (MEM_CIRC_2) has an RWB input terminal (RWB) for receiving a signal indicating a read access or a write access to the main memory block (MEM), and
- the control mean (CONTR_LOG) comprises an AND gate (AND) having a first input terminal connected to the output terminal of the comparator (COMP), a second input terminal connected to the CSB input terminal (CSB) via a second inverter (INV_2), a third input terminal connected to the RWB input terminal (RWB) and an output terminal connected to a control terminal of the multiplexer (MUX).

9. A method of controlling an access to a memory circuit (MEM_CIRC_2) comprising a main memory block (MEM) and a substitution memory block (RED_REG) for substitution of faulty memory cells in the main memory block (MEM), with the method being comprised of the following steps:
(a) Activating the substitution memory block (RED_REG) and leaving the main memory block (MEM) inactivated in case of an access to a faulty memory cell; and
(b) Redirecting this access to the substitution memory block (RED_REG).

10. The method according to claim 9,
**characterized in that**
- the addresses involved in an access to the memory circuit (MEM_CIRC_2) are compared with the addresses of the faulty memory cells.

11. The method according to claim 9 or according to claim 10,
**characterized in that**
- the main memory block (MEM) is activated and the substitution memory block (RED_REG) is left inactivated in case of an access to a faultless memory cell and this access is directed to the main memory block (MEM).

12. The method according to one or more of the claims 9 to 11,
**characterized in that**
- the memory circuit (MEM_CIRC_2) comprises a non-volatile address memory (ADDR_MEM), in which the addresses of faulty memory cells of the main memory block (MEM) are stored.

13. The method according to one or more of the claims 9 to 12,
**characterized in that**
- an access to the memory circuit (MEM_CIRC_2) is a read or a write access.
